# EUROPEAN PATENT APPLICATION

(11) **EP 0 865 044 A1**
(43) Date of publication of application: **16.09.1998**
(21) Application number: 97830107.5
(22) Date of filing: 11.03.1997
(51) Int. Cl.: G11C 11/412, G11C 11/419

(54) **Memory device with reduced read power dissipation**

(71) Applicant: STMicroelectronics S.r.l., 20041 Agrate Brianza (Milano) (IT)
(72) Inventor: Rimondi, Danilo, 24030 Mozzo (Bergamo) (IT); Torelli, Cosimo, 15057 Tortona (Alessandria) (IT)
(74) Representative: Mittler, Enrico

(57) **Abstract**

A memory cell comprises a bistable element (I1,I2) with a first (A) and a second nodes (B) storing complementary data, first (N3) and second selection means (N4) for respectively coupling the first (A) and second nodes (B) to a first (0) and a second input/output nodes (0') of the memory cell (1). The first (N3) and second selection means (N4) are respectively controlled by independent first (WL_{r/w}) and second selection signals (WL_{w}).

## Description

The present invention pertains to the field of integrated circuits, particularly to integrated memory circuits. More particularly, the invention relates to integrated static Random Access Memories (static RAMs or, shortly, SRAMs).

Conventional static RAMs comprise a bidimensional array of memory cells, arranged in rows (word lines) and columns (bit lines), each memory cell being placed at the intersection of a word line with a bit line. Row and column selection circuits are provided for selecting the desired rows and columns of the array.

Most SRAMs have memory cells comprised of six transistors, for example of the CMOS logic family, and are therefore called "6T cells SRAMs". Each memory cell comprises two cross-coupled CMOS inverters (the output of one inverter being coupled to the input of the other, and vice-versa) forming a latch, and two selection transistors (pass-transistors), each connected between the output of a respective one of the two CMOS inverters and a respective one of two complementary bit lines; the gates of the two selection transistors are electrically connected to a same word line of the array. This means, each column of the memory array is actually composed of two complementary bit lines.

During the read access to the memory device, the potential of all the bit lines is held high (i.e., the bit lines are precharged at the supply voltage of the memory device); a given memory cell will have a "1" stored at the output of a first one of the two CMOS inverters, and a "0" stored at the output of the second CMOS inverters. When the word line to which the memory cell is connected is set to "1", the selection transistors are turned on; the one of the two complementary bit lines coupled to the output of the inverter which is set to "0" is consequently discharged through the selection transistor and the pull-down transistor of such inverter.

To program (write) a given memory cell, one of the two complementary bit lines is pulled low and the other is pulled high, and then the word line to which the memory cell is connected is set to "1", in order to turn the selection transistors on. Assuming for example that the output of the inverter coupled to the bit line set to "0" initially stores a "1", when the selection transistors are turned on, since the pull-up transistor of such inverter is sized such that the output of the inverter is pulled down enough to turn the pull-up transistor of the other inverter on, the output of the other inverter is pulled high; the cross-coupled connection of the two inverters provides a high gain, so that the outputs of the two inverters can switch to opposite voltages.

According to this arrangement, the power dissipation of the memory cell array during the read access to the memory device is a well determined quantity depending on measurable parameters, such as the capacitance of the bit lines, the voltage swing of the bit lines and the number of memory cells which are simultaneously selected.

All the known techniques used to reduce the memory array power dissipation are directed towards a reduction of the value of one or more of said parameters.

6T cells SRAMs have also been proposed with single bit line architecture instead of the complementary bit lines architecture previously described. The object of the single bit line architecture is to reduce the silicon area.

However, the single bit line architecture has the main drawback of requiring particular circuit solutions to perform a safe programming of the memory cells.

In view of the state of the art described, it is a first object of the present invention to provide a new memory cell having a structure suitable for allowing to reduce the power dissipation of a memory cell array during the read access thereof, without requiring complex circuit solutions for safe reading and programming of the memory cell.

It is a second object of the invention to provide a memory device having a memory cell array formed by said new memory cells.

According to the present invention, the first object is achieved by means of a memory cell comprising a bistable element with a first and a second nodes storing complementary data, first and second selection means for respectively coupling the first and second nodes to a first and a second input/output nodes of the memory cell, characterized in that said first and second selection means are respectively controlled by independent first and second selection signals.

Also according to the present invention, said second object is achieved by means of a memory device comprising a bidimensional array of memory cells arranged in rows and columns, column selection circuit means for selecting the columns, row selection circuit means for selecting the rows, each column comprising a respective pair of complementary bit lines, each memory cell comprising a bistable element with a first and a second nodes storing complementary data, first and second selection means for respectively coupling the first and second nodes to a first and a second input/output nodes of the memory cell, the first input/output node connected to a first bit line of the pair of complementary bit lines and the second input/output node connected to a second bit line of the pair, characterized in that each row comprises a first and a second word line, the first word line controlling the first selection means of all the memory cells of the row, and the second word line controlling the second selection means of all the memory cells of the row, and in that said first and second word lines being respectively activated and deactivated when a selected memory cell of the corresponding row is to be read so that the first node of the selected memory cell is electrically connected to the first bit line of the pair of complementary bit lines of the column.

Thanks to the present invention, it is possible to reduce the power dissipation of the memory device during a read access thereto. In fact, thanks to the fact that the selection means of each memory cell can be individually activated, during a read access to the memory device only one of the complementary bit lines to which the selected memory cell is connected is discharged. Because statistically half of the memory cells of the array will store a datum, and the other half the complementary datum, only a half of the bit lines of the memory array will undergo a discharge, and the power dissipation will be reduced to approximately 50%.

These and other features and advantages of the present invention will be made apparent by the following detailed description of a particular embodiment thereof, illustrated by way of a non-limiting example in the accompanying drawings, wherein:
Figure 1 shows the circuit structure of a memory cell according to the present invention; and
Figure 2 shows a portion of a memory cell array according to the present invention.

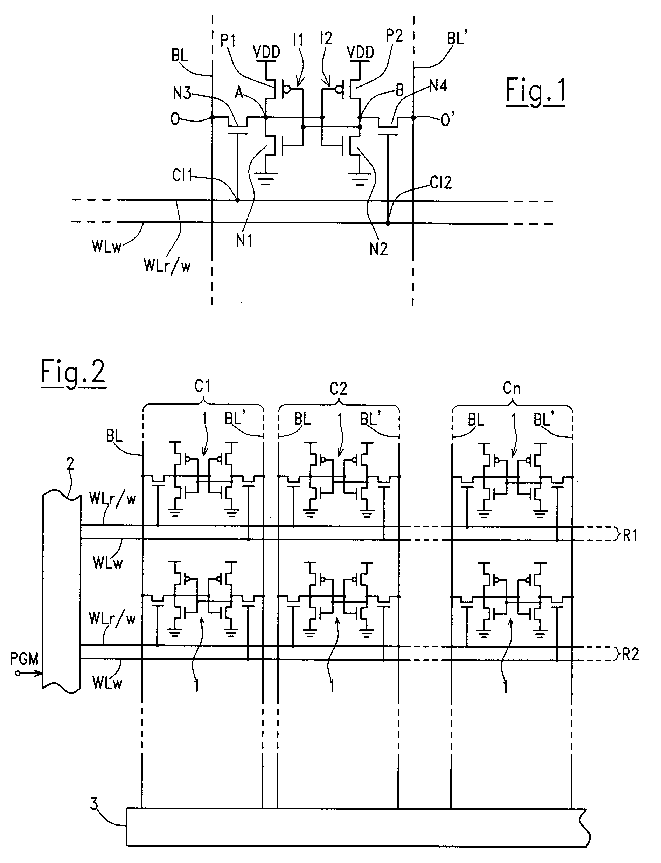

With reference to the drawings, Figure 1 shows the circuit structure of a six-transistor memory cell 1 for a Static Random Access Memory (SRAM). The memory cell 1 conventionally comprises two inverters I1, I2, for example of the CMOS type. Inverter I1 comprises a P-channel pull-up MOSFET P1 and an N-channel pull-down MOSFET N1 connected in series between a voltage supply VDD and ground. Inverter I2 similarly comprises a P-channel pull-up MOSFET P2 and an N-channel pull-down MOSFET N2 connected in series between VDD and ground. An output node A of inverter I1 is connected to the input node of inverter I2 (i.e., to the gates of P2 and N2); similarly, an output node B of inverter I2 is connected to an input node of inverter I1 (i.e., to the gates of P1 and N1). The memory cell 1 further comprises a first and a second selection transistors N3, N4, formed for example by N-channel MOSFETs: N3 couples node A to a first input/output node 0 of the memory cell 1, while N4 couples node B to a second, logically complemented input/output node 0' of the memory cell. Node 0 is connected to a first bit line BL of a pair of complementary bit lines, and node 0' is connected to a second bit line BL' of said pair.

According to the present invention, the memory cell 1 has two control inputs CI1, CI2 respectively connected to the gates of selection transistors N3 and N4. Control input CI1 is connected to a first word line WL_{r/w} of a pair of word lines, while control input CI2 is connected to a second word line WL_{w} of said pair.

The memory cell 1 is accessed to be read by precharging the pair of complementary bit lines BL and BL' at the supply voltage VDD, as for conventional 6T SRAMs memory cells; to select the memory cell, only the word line WL_{r/w} is set high, while word line WL_{w} is kept grounded. In this way, only selection transistor N3 is turned on, N4 remaining off. The bit line BL is thus connected to node A of the memory cell. If the datum stored in the memory cell is A="1", B="0", the potential of bit line BL remains unchanged; if instead the datum stored in the memory cell is A="0", B="1", bit line BL will be discharged through N3 and N1. In both cases, however, bit line BL' is isolated and it is not discharged.

Differently, in conventional 6T memory cells SRAMs wherein both the selection transistors are driven by a same word line of the array, during a read operation of the memory cells one of the pair of complementary bit lines is always discharged.

Thanks to the provision of two indepenent control signals for the selection transistors of each memory cell, because on a statistical basis a half of the memory cells of the memory array store data corresponding to A="0", B="1", and the other half store data corresponding to A="1", B="0", only a half of the bit lines of the memory array are discharged. This translates in a reduction of the power dissipation of the memory array which, on a statistical basis, is of 50%.

When the memory cell 1 is to be programmed, one bit line of the pair BL, BL' is held high, while the other bit line of the pair is grounded, as in the conventional case; both the word lines WL_{r/w} and WL_{w} are activated (i.e. switched high), so that both selection transistors N3 and N4 are turned on; the memory cell thus behaves as a conventional 6T SRAM memory cell.

Figure 2 shows the structure of a portion of a memory cell array according to the present invention. The shown memory array portion comprises two rows R1, R2 and three columns C1, C2, Cn; each column is comprised of a pair of complementary bit lines BL, BL', as in the conventional architecture; according to the invention, each row is composed of a pair of word lines WL_{r/w} and WL_{w}, the former activated both in read and in program mode, the latter activated only in program mode. Row and column selection circuit blocks 2 and 3 are also schematically shown; the column selection circuit block 3 can be any of the known type of column selection circuit provided in conventional 6T memory cell SRAMs; row selection circuit block 2, differently from conventional row selection circuits, has to allow the selective control of the pairs of word lines of each row, depending on the operating mode of the memory device (read or program mode). Schematically, a mode selection signal PGM supplies the row selection circuit block 2 to inform the latter of the operating mode: in read mode, only the word line WL_{r/w} of the selected row R1 or R2 will be activated, while in program mode both word lines WL_{r/w} and WL_{w} of the selected row will be activated.

## Claims

1. A memory cell comprising a bistable element (I1,I2) with a first (A) and a second nodes (B) storing complementary data, first (N3) and second selection means (N4) for respectively coupling the first (A) and second nodes (B) to a first (0) and a second input/output nodes (0') of the memory cell (1), characterized in that said first (N3) and second selection means (N4) are respectively controlled by independent first (WL_{r/w}) and second selection signals (WL_{w}).

2. The memory cell according to claim 1, characterized in that the first (WL_{r/w}) and second selection signals (WL_{w}) are respectively activated and deactivated to read the memory cell (1), so that the first node (A) of the bistable element (I1,I2) is electrically connected to the first input/output node (0) of the memory cell through said first selection means (N3) while said second input/output node (0') is isolated from said second node (B) of the bistable element.

3. The memory cell according to claim 2, characterized in that the first (WL_{r/w}) and second selection signals (WL_{w}) are both activated to write the memory cell (1).

4. The memory cell according to claim 3, characterized in that said bistable element (I1,I2) comprises two cross-coupled inverters (I1,I2), the first node (A) being an output of a first inverter (I1) and the second node (B) being an output of a second inverter (I2).

5. The memory cell according to claim 4, characterized in that said inverters (I1,I2) are CMOS inverters.

6. The memory cell according to claim 5, characterized in that said first (N3) and second selection means (N4) comprise each a transistor with first and second terminals connected between the first node (A), or respectively the second node (B), of the bistable element (I1,I2) and the first input/output node (0), or respectively the second input/output node (0'), of the memory cell (1), and a control terminal connected to the first selection signal (WL_{r/w}), or respectively the second selection signal (WL_{w}).

7. The memory cell according to claim 6, characterized in that said transistor is a MOSFET.

8. A memory device comprising a bidimensional array of memory cells (1) arranged in rows (R1,R2) and columns (C1-Cn), column selection circuit means (3) for selecting a column, row selection circuit means (2) for selecting a row, each column comprising a respective pair of complementary bit lines (BL,BL'), each memory cell (1) comprising a bistable element (I1,I2) with a first (A) and a second nodes (B) storing complementary data, first (N3) and second selection means (N4) for respectively coupling the first (A) and second nodes (B) to a first (0) and a second input/output nodes (0') of the memory cell (1), the first input/output node (0) connected to a first bit line (BL) of the pair of complementary bit lines and the second input/output node (0') connected to a second bit line (BL') of the pair, characterized in that each row (R1,R2) comprises a first (WL_{r/w}) and a second word line (WL_{w}), the first word line (WL_{r/w}) controlling the first selection means (N3) of all the memory cells (1) of the row, and the second word line (WL_{w}) controlling the second selection means (N4) of all the memory cells of the row, and in that said first and second word lines being respectively activated and deactivated when a selected memory cell of the corresponding row is to be read so that the first node (A) of the selected memory cell is electrically connected to the first bit line (BL) of the pair of complementary bit lines of the column.

9. The memory device according to claim 8, characterized in that said first and second word lines (WL_{r/w},WL_{w}) of a selected row (R1,R2) are both activated when a selected memory cell of the selected row is to be programmed.

10. The memory device according to claim 9, characterized in that said bistable element (I1,I2) comprises two cross-coupled inverters (I1,I2), the first node (A) being an output of a first inverter (I1) and the second node (B) being an output of a second inverter (I2).

11. The memory device according to claim 10, characterized in that said inverters (I1,I2) are CMOS inverters.

12. The memory device according to claim 11, characterized in that said first (N3) and second selection means (N4) comprise each a transistor with first and second terminals connected between the first node (A), or respectively the second node (B), of the bistable element (I1,I2) and the first input/output node (0), or respectively the second input/output node (0'), of the memory cell (1), and a control terminal connected to the first word line (WL_{r/w}) of the row to which the memory cell belongs, or respectively the second word line (WL_{w}) of the row.

13. The memory device according to claim 12, characterized in that said transistor is a MOSFET.

14. The memory device according to any one of claims 8 to 13, characterized in that it is a static RAM device.
